# EUROPEAN PATENT SPECIFICATION

(11) **EP 2 681 765 B1**
(45) Date of publication and mention of the grant of the patent: **06.04.2022**
(21) Application number: 12752146.6
(22) Date of filing: 29.02.2012
(51) Int. Cl.: H01L 23/48, H01L 21/60, H01L 23/66, H01L 23/498, H01L 23/00

(54) **Apparatus and method related to reduction of RF signal losses**
Vorrichtung und Verfahren zur Reduzierung von HF-Signalverlusten
Appareils et procédé liés à la réduction des pertes de signaux RF

(30) Priority: 03.03.2011 US 201113040127; 03.03.2011 US 201113040137
(43) Date of publication of application: 08.01.2014
(73) Proprietor: Skyworks Solutions, Inc., Woburn, MA 01801 (US)
(72) Inventor: SUN, Weimin, Santa Rosa Valley, CA 93012 (US); ZAMPARDI, JR., Peter, Joseph, Newbury Park, CA 91320 (US); SHAO, Hongxiao, Thousand Oaks, CA 91362 (US)
(74) Representative: Lloyd, Patrick Alexander Desmond
(86) International application number: PCT/US2012/027130
(87) International publication number: WO 2012/118896

(56) References cited:
- EP-A2- 1 087 648
- EP-A2- 1 087 648
- JP-A- 2005 093 545
- US-A1- 2003 160 307
- US-A1- 2003 160 307
- US-A1- 2008 206 927
- US-A1- 2008 315 356
- US-A1- 2008 315 356
- US-A1- 2009 209 064
- US-A1- 2009 209 064
- US-A1- 2011 006 415
- US-A1- 2011 006 415
- US-B1- 6 759 597
- US-B2- 7 880 275
- US-B2- 7 880 275

## Description

### PRIORITY CLAIM

### BACKGROUND

### Field

The present disclosure generally relates to the field of integrated circuit layout and packaging, and more particularly to systems and methods of layout and forming wire bond pads for packaging of Radio Frequency (RF) integrated circuits (ICs).

### Description of the Related Art

Silicon or other semiconductor wafers are fabricated into integrated circuits (ICs) as is known to one of ordinary skill in the art of IC fabrication. An IC is bonded and electrically connected to a carrier or substrate, which has layers of dielectric and metal traces, and packaged for use. A surface plating material is plated onto the top layer of copper traces to provide electrical connection points between the IC and the substrate, permitting the IC to interface with the outside world. Traditionally, nickel/gold (Ni/Au) has been a standard surface plating material for RFIC products and in certain situations, the RFIC is wire-bonded to the Ni/Au wire-bond pads plated on the surface of the substrate to form the electrical connections of the RFIC with its package. However, increases in gold prices have increased packaging costs associated with the Ni/Au surface plating.

US patent application with publication number US 2008/206927 discloses an external component, typically a surface mounted passive component, attached to a semiconductor die. The passive component may be placed directly over exposed pads on the semiconductor die and attached using conductive tape or conductive epoxy; or the passive component may be attached to the semiconductor die using non-conductive adhesive and wire bonded to bond pads on the semiconductor die and/or to pads on a substrate to which the semiconductor die is attached.

Japanese patent application with publication number JP2005093545 discloses a semiconductor circuit device in which a bonding pad is arranged at a former side of an intersecting portion of a signal course, and one side's wiring is carried out overhead by a bonding wire so that wiring of a signal source is made not so long, and parasitic capacitance at the intersecting portion is reduced. In a shunt circuit, a capacitor which carries out series resonance with inductance of the bonding wire or a terminal at a specific frequency is inserted in the former side of a GND, thereby forming a trap with respect to the frequency.

### SUMMARY

The invention is defined by the independent claims to which reference should now be made. Optional features are set forth in the dependent claims.

An electronic circuit module configured to reduce signal losses is disclosed. The module comprises an electronic circuit device having an output signal and a current associated therewith. Said electronic circuit device includes a first lead, a second lead, and an integrated circuit die having an on-die passive component. The electronic circuit module further comprises a substrate including a trace for conducting said current. Said trace has a first bonding pad thereon electrically connected to said first lead and a second bonding pad located on the trace between the first bonding pad and the output of the electronic circuit module and being electrically connected to said second lead. Said electronic circuit device is configured such that said on-die passive component electrically connects to said first lead and said output signal electrically connects to said second lead. Said current thereby being directed away from said first bonding pad. The electronic circuit module is a radio frequency integrated circuit module and the signal losses are radio frequency signal losses. The electronic circuit device is a radio frequency electronic circuit device, the output signal is a radio frequency output signal, and the current is a radio frequency current.

A method for fabricating an electronic circuit module for reducing signal losses in the electronic circuit module is disclosed. The method comprises fabricating an electronic circuit device including an integrated circuit die having an on-die passive component, and configured for generating an output signal from the electronic circuit device. Said output signal has an associated current. The method further comprises forming a first lead and a second lead on the electronic circuit device, forming a first bonding pad and a second bonding pad on a substrate, and forming a trace on the substrate to provide a conductive path to conduct the current between the first and the second bonding pads and from the said output to an output of the electronic circuit module. The method further comprises electrically connecting the first lead to the first bonding pad, electrically connecting the second lead to the second bonding pad, the first bonding pad being located on the trace, the second bonding pad being located on the trace between the first bonding pad and the output of the electronic circuit module, and configuring the electronic circuit device so that the on-die passive component electrically connects to the first lead and the output signal electrically connects to the second lead. The current thereby being directed away from the first bonding pad. The electronic circuit device is a radio frequency electronic circuit device, the output signal is a radio frequency output signal, and the current is a radio frequency current.

For purposes of summarizing the disclosure, certain aspects, advantages and novel features of the inventions have been described herein. It is to be understood that not necessarily all such advantages may be achieved in accordance with any particular embodiment of the invention. Thus, the invention may be embodied or carried out in a manner that achieves or optimizes one advantage or group of advantages as taught herein without necessarily achieving other advantages as may be taught or suggested herein.

### BRIEF DESCRIPTION OF THE DRAWINGS

FIGURE 1 illustrates an enlarged portion of an exemplary IC module comprising a wire bond pad, according to certain embodiments not falling within the scope of the present invention.

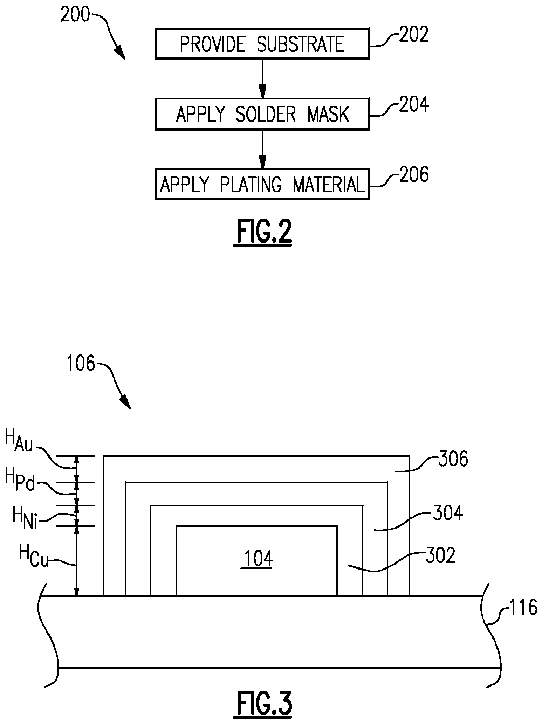

FIGURE 2 illustrates a flow chart for an exemplary process for forming wire bond pads not falling within the scope of the present invention.
FIGURE 3 illustrates a cross-section of a Ni/Pd/Au wire bond pad on the IC module of FIGURE 1, according to an embodiment not falling within the scope of the present invention.

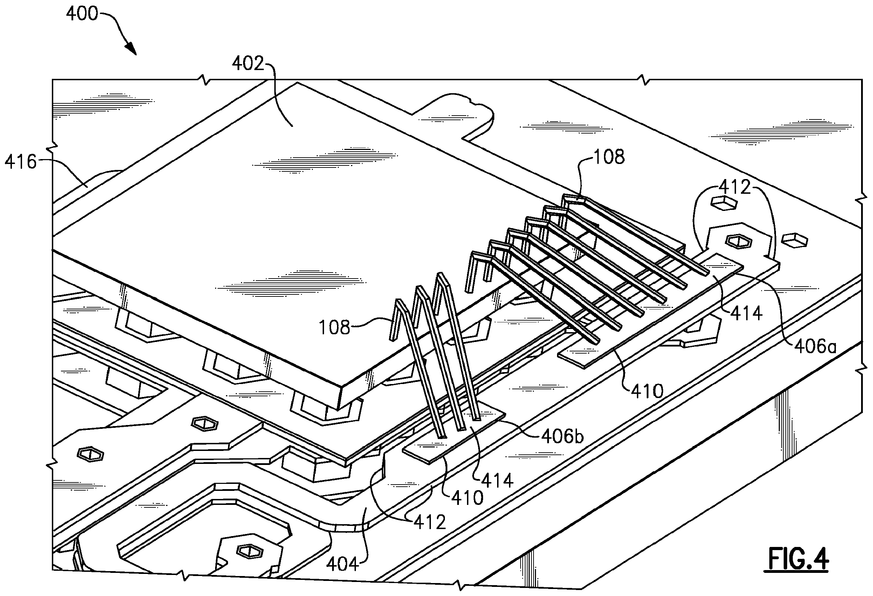

FIGURE 4 illustrates an enlarged portion of an exemplary RFIC module comprising a wire bond pad, according to certain embodiments not falling within the scope of the present invention.

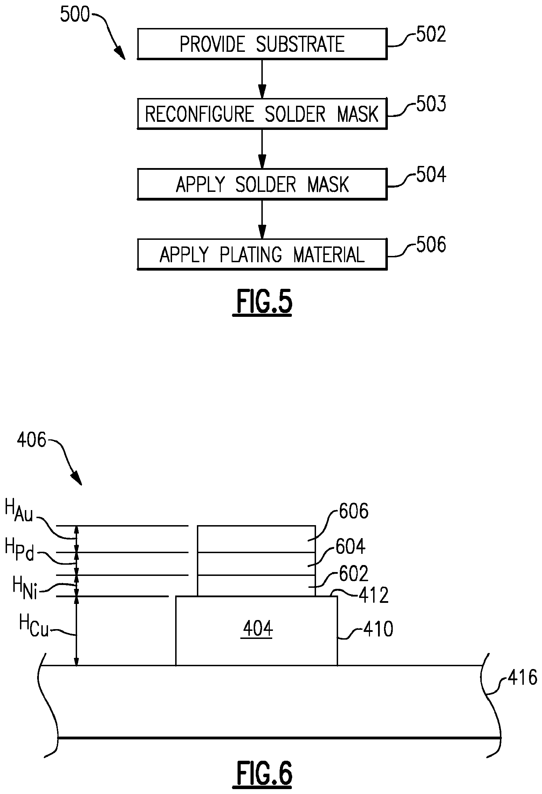

FIGURE 5 illustrates a flow chart for an exemplary process for forming Ni/Pd/Au wire bond pads, according to certain embodiments not falling within the scope of the present invention.
FIGURE 6 illustrates a cross-section of a Ni/Pd/Au wire bond pad on the RFIC module of FIGURE 4, according to an embodiment not falling within the scope of the present invention.

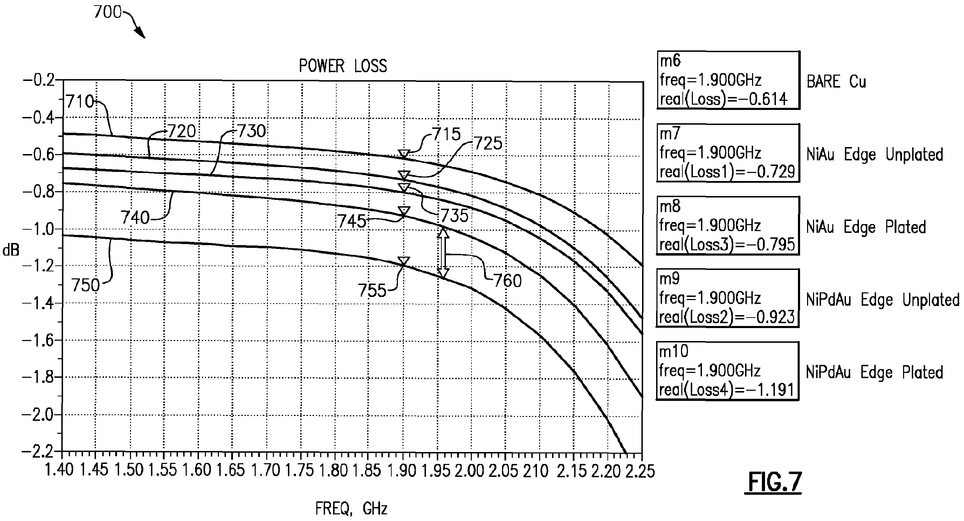

FIGURE 7 is a graph comparing the RF losses for traces with edge/sidewall exposed surfaces and edge/sidewall plated surfaces, according to certain embodiments embodiment not falling within the scope of the present invention.

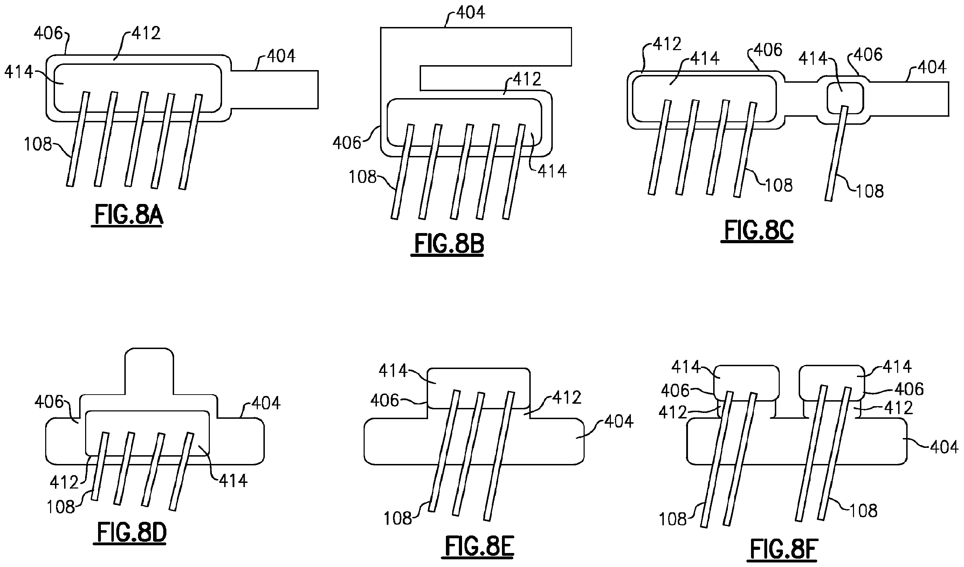

FIGURES 8A-8F illustrate exemplary layouts for wire-bonding areas having minimized edges and sidewalls exposed to plating not falling within the scope of the present invention.
FIGURE 9 illustrates an enlarged portion of an RFIC module having an RFIC with an on-die passive device, according to an embodiment not falling within the scope of the present invention.
FIGURE 10 illustrates an enlarged portion of an RFIC module having an RFIC with an on-die passive device, according to the present invention.

### DETAILED DESCRIPTION OF CERTAIN EMBODIMENTS

The features of the systems and methods will now be described with reference to the drawings summarized above. Throughout the drawings, reference numbers are re-used to indicate correspondence between referenced elements. The drawings, associated descriptions, and specific implementation are provided to illustrate embodiments of the inventions and not to limit the scope of the claims.

Wire bonding is a technique for connecting electrical circuit devices, for example, integrated circuit (IC) die, to the next level of packaging. These circuit devices generally comprise a plurality of small conductive leads/pads that are electrically connected, for example, by ball bonding, wedge bonding, or the like, to wire bond pads on conductors embedded in the device package or substrate. The wire bond pads on the substrate provide the electrical connections between the IC and the substrate, permitting the IC to interface with the outside world. In either type of wire bonding, the wire is attached at both ends using some combination of heat, pressure, and ultrasonic energy to make a weld.

A plurality of copper patterns is formed on a substrate which is electrically connected to the circuit patterns, and a filler, such as a dielectric, is filled between the copper patterns such that an upper surface of the copper pattern is exposed. However, bare copper is not readily solderable or bondable and requires plating with a material that facilitates soldering or bonding. Areas that should not be solderable/bondable are covered with a material to resist plating. In general, solder resist refers to a polymer coating that acts as a mask and prevents the plating material from adhering to the masked copper traces. A surface plating material is plated onto the top layer of exposed copper traces to provide the wire bond pads. In some applications, wire bond pads are suited for wire bonding directly over active circuits to avoid damaging fragile devices and to lower metal resistance for power integrated circuits.

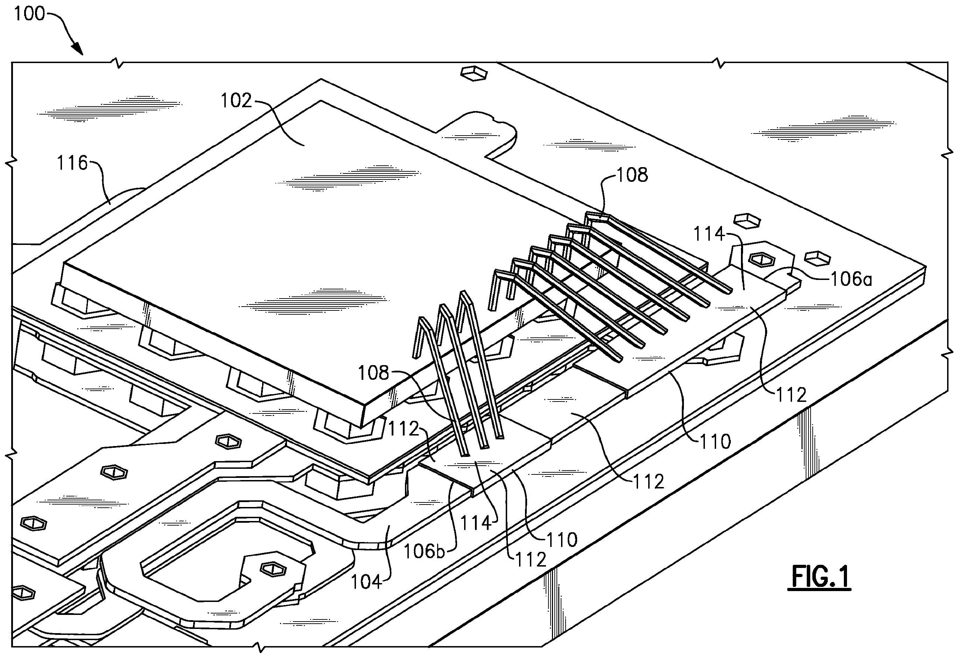

FIGURE 1 illustrates a portion of an IC module 100 comprising an IC 102, a substrate 116, a copper trace 104, wire bond pads 106a, 106b, and bonding wires 108, according to an embodiment. The IC is wire bonded to wire bond pads 106 through wires 108. In the illustrated embodiment, wire bond pad 106a is a 6-wire wire bond pad and wire bond pad 106b is a 3-wire wire bond pad. In other embodiment, other numbers of wires 108 can be attached to the wire-bond pads 106. Wire bond pad 106 comprises a bond area 114, sidewalls 110, and edges 112.

Wafer fabrication generally refers to the process of building integrated circuits on silicon or semiconductor wafers. Many processes exist, known to one of ordinary skill in the art of wafer fabrication, such as, for example, epitaxy, masking and etching, diffusion, ion implant, deposition of polysilicon, dielectric fabrication, lithography/etching, deposition of thin films, metallization, glassivation, probing/trimming of each die on the wafer, and the like, to create integrated circuits to the designers specifications.

It can be desirable to locate an on-die passive device, such as a resistor, capacitor, inductor, or the like, on a RFIC, which further comprises an RF output signal. The on-die passive device can function as a filter, a shunt filter, a trapper for harmonic frequencies, or the like, in the RF circuit.

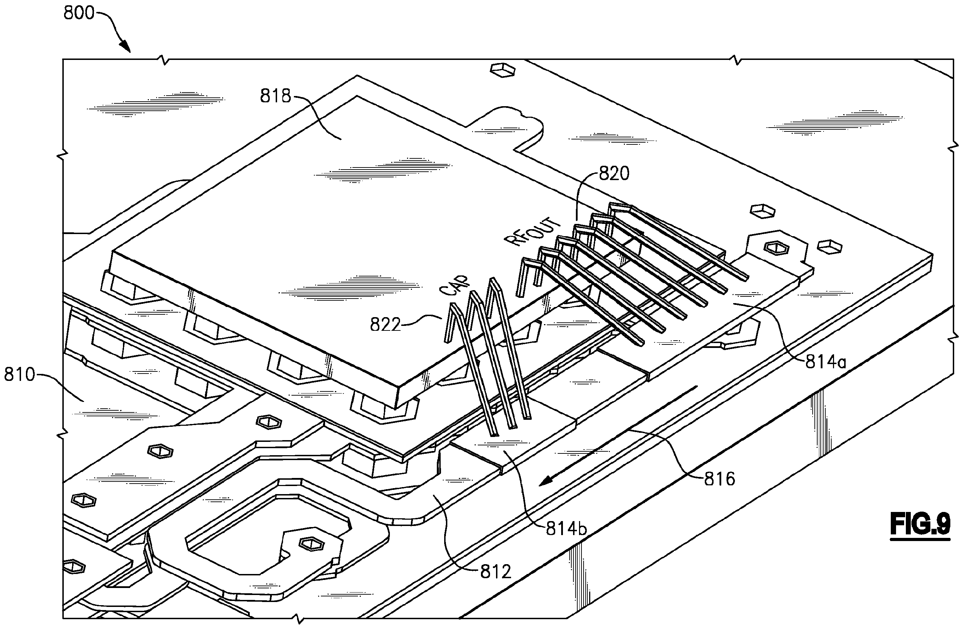

FIGURE 9 illustrates an enlarged portion of an RFIC module 800 not falling within the scope of the present invention comprising a substrate 810 and an RFIC 818. Additional circuitry is omitted for simplicity. The substrate 810 comprises an RFIC circuit trace 812, and wire-bonding pads 814a, 814b. In an embodiment, the wire-bonding pads 814a, 814b comprise Ni/Pd/Au. In another embodiment, the wire-bonding pads 814a, 814b comprise a high RF loss plating material. In a further embodiment, the wire bonding pads 814a, 814b comprise Ni/Au. In an embodiment, the wire bonding pads 814a, 814b are formed with plated edges and sidewalls, as illustrated in FIGURE 9. In another embodiment, the wire bonding pads 814a, 814b are formed with edges and sidewalls free from the surface plating material.

The RFIC 818 comprises an RF output 820, and an on-die passive device 822, such as a capacitor 822. The RF output 820 is the location on the RFIC 818 from which the RF output signal from the RFIC's internal circuitry exits the RFIC 818 and inputs into the RF circuitry of the module 800. In an embodiment, the layout of the RFIC 818 is configured such that the capacitor 822 is placed in the RF circuit 812 of the RF module 800 after the RF output 820. In this layout, when the RF output 820 is wire bonded to wire bonding pad 818a and the on-die capacitor 822 is wire bonded to wire bonding pad 814b, the on-die capacitor 822 is between the RF output 820 of the RFIC 818 and the RF output of the module 800.

An arrow 816 indicates the direction of RF current flow of the RF signal. As shown, the RF current flows from the RF output signal 820 to the RF output of the module 800. Portions of the RF trace 812 that are between the RF output signal 820 and the RF output of the module 800 are in the RF signal down path and portions of the trace 812 that are located above the RF output 820 that do not receive the RF current flow are in the RF signal upper path. In FIGURE 9, the capacitor bonding pad 814b is located in the RF down path. In other words, the RF current passes through the capacitor wire-bond pad 814b when traveling from the RF output 820 to the rest of the circuitry on the substrate 810.

In certain circumstances, passing the RF signal through the high RF loss plating material, such as the Ni/Pd/Au capacitor bonding pad 814b, creates additional RF signal losses.

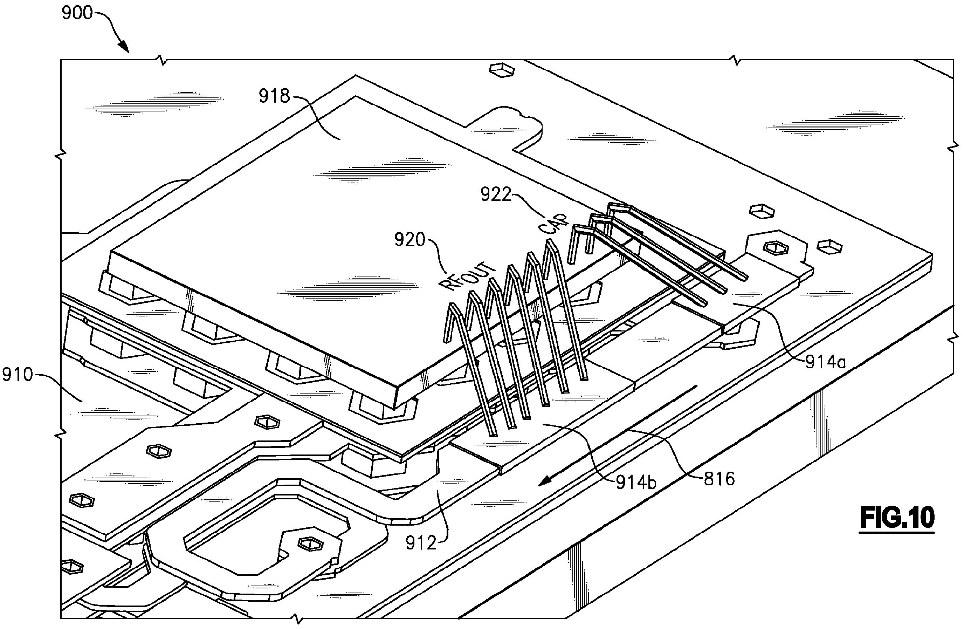

FIGURE 10 illustrates the enlarged portion of an RFIC module 900 comprising a substrate 910 and an RFIC 918 according to the present invention.

Additional circuitry is omitted for simplicity. The substrate 910 comprises an RFIC circuit trace 912, and wire-bonding pads 914a, 914b. In an embodiment, the wire-bonding pads 914a, 914b comprise Ni/Pd/Au. In another embodiment, the wire-bonding pads 914a, 914b comprise a high RF loss plating material. In a further embodiment, the wire bonding pads 914a, 914b comprise Ni/Au. In an embodiment, the wire bonding pads 914a, 914b are formed with plated edges and sidewalls, as illustrated in FIGURE 10. In another embodiment, the wire bonding pads 914a, 914b are formed with edges and sidewalls free from the surface plating material.

The layout of the RFIC 918 has been reconfigured to reduce the RF losses associated with the RF current flowing through the high RF loss bonding pad of the on-die passive device. The RFIC 918 comprises an RF output 920, and an on-die passive device 922, such as a capacitor 922. The RF output 920 is the location on the RFIC 918 from which the RF output signal from the RFIC's internal circuitry exits the RFIC 918 and inputs into the RF circuitry of the module 900. In an embodiment, the layout of the RFIC 918 is configured such that the capacitor 922 is placed in the RF circuit 912 of the RF module 900 before the RF output 920. In this layout, when the RF output 920 is wire bonded to wire bonding pad 918b and the on-die capacitor 922 is wire bonded to wire bonding pad 814a, the on-die capacitor 922 is not between the RF output 920 of the RFIC 918 and the RF output of the module 900.

The arrow 816 again indicates the direction of RF current flow of the RF signal. As shown, the RF current flows from the RF output signal 920 to the RF output of the module 900. In FIGURE 10, the passive device bonding pad 914a is located in the RF upper path. In other words, the RF current does not pass through the passive device wire-bond pad 914a when traveling from the RF output 920 to the rest of the circuitry on the substrate 910. Thus, placing the on-die passive device in the layout of the RFIC 918 such that bonding pad 914a on the substrate 910 for the on-die passive device is in the RF upper signal path reduces the RF signal loss that is associated with placing the on-die passive device bonding pad 914a in the RF signal down path.

To reduce costs, in certain circumstances, Ni/Pd/Au instead of Ni/Au is plated onto the surface traces of substrates for RFIC modules to form wire-bond areas. However, Ni/Pd/Au has a higher RF sheet resistance than Ni/Au and this leads to higher RF losses for signals traveling through Ni/Pd/Au wire-bond areas than for signals traveling through Ni/Au wire-bond areas. To reduce the RF losses associated with high RF loss plating, such as, for example, Ni/Pd/Au plating, an on-die passive device, such as a capacitor, resistor, inductor, or the like, associated with an RFIC is placed in an RF upper path with respect to the RFIC output signal. By laying out the IC with the passive device in the RF signal upper path, the RF signal current does not pass through the high RF loss bonding pad of the passive device when module is assembled.

While examples have been described with respect to Ni/Pd/Au surface plating, the disclosed systems and methods apply to any high RF loss surface plating, such as, for example, Sn, Pb, other surfaces of ferromagnetic materials, and the like.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." The words "coupled" or connected", as generally used herein, refer to two or more elements that may be either directly connected, or connected by way of one or more intermediate elements. Additionally, the words "herein," "above," "below," and words of similar import, when used in this application, shall refer to this application as a whole and not to any particular portions of this application.

## Claims

1. An electronic circuit module (900) configured to reduce signal losses, said module comprising:
an electronic circuit device (918) including: an integrated circuit die having an on-die passive component (922), an output (920) configured to provide an output signal having an associated current to the electronic circuit module (900), a first lead and a second lead;
a substrate (910) including a trace (912) for conducting the current from said output (920) to an output of the electronic circuit module, the trace having a first bonding pad (914a) thereon electrically connected to the first lead and a second bonding pad (914b) located on the trace (912) between the first bonding pad (914a) and the output of the electronic circuit module and being electrically connected to the second lead, said electronic circuit device configured such that said on-die passive component (922) electrically connects to said first lead and said output (920) signal electrically connects to the second lead, the current thereby being directed away from the first bonding pad, the electronic device being a radio frequency electronic circuit device, the output signal being a radio frequency output signal, and the current being a radio frequency current.

2. The electronic circuit module of claim 1 wherein the first and the second bonding pads (914a, 914b) are plated with a surface plating material including nickel, palladium, and gold.

3. The electronic circuit module of claim 1 or claim 2 wherein the first bonding pad (914a) and the second bonding pad (914b) each include at least one edge, at least one sidewall, and a bonding area, the at least one edge and the at least one sidewall of each of the first and the second bonding pads (914a, 914b) being free from plating material.

4. The electronic circuit module of any of claims 1 to 3 wherein the first bonding pad (914a) and the second bonding pad (914b) are wire bonding pads.

5. A method for fabricating an electronic circuit module (900) for reducing signal losses in the electronic circuit module, the method comprising:
fabricating an electronic circuit device (918) including: an integrated circuit die having an on-die passive component (922), and an output (920) configured to provide an output signal having an associated current to the electronic circuit module (900), the electronic circuit module comprising the electronic circuit device;
forming a first lead and a second lead on the electronic circuit device;
forming a first bonding pad (914a) and a second bonding pad (914b) on a substrate (910), the electronic circuit module comprising the substrate (910);
forming a trace (912) on the substrate (910) to provide a conductive path to conduct the current between the first and the second bonding pads (914a, 914b) and from said output (920) to an output of the electronic circuit module;
electrically connecting the first lead to the first bonding pad (914a);
electrically connecting the second lead to the second bonding pad (914b), the first bonding pad being located on the trace, the second bonding pad being located on the trace (912) between the first bonding pad (914a) and the output of the electronic circuit module; and
configuring the electronic circuit device so that the on-die passive component (922) electrically connects to the first lead and the output signal electrically connects to the second lead, the current thereby being directed away from the first bonding pad during use, the electronic circuit device being a radio frequency electronic circuit device, the output signal being a radio frequency output signal, and the current being a radio frequency current.

## Patentansprüche

1. Elektronisches Schaltungsmodul (900), das zur Verringerung von Signalverlusten konfiguriert ist, wobei das genannte Modul Folgendes umfasst:
eine elektronische Schaltungsvorrichtung (918) mit:
einem Nacktchip mit integrierter Schaltung, der ein auf dem Nacktchip untergebrachtes passives Bauelement (922) aufweist, einem Ausgang (920), der zum Anlegen eines Ausgangssignals, das einen zugehörigen Strom aufweist, an das elektronische Schaltungsmodul (900) konfiguriert ist,
einer ersten Anschlussleitung und einer zweiten Anschlussleitung;
ein Substrat (910) mit einer Leiterbahn (912) zum Leiten des Stroms von dem genannten Ausgang (920) zu einem Ausgang des elektronischen Schaltungsmoduls, wobei die Leiterbahn auf ihr eine erste Anschlussfläche (914a), die elektrisch mit der ersten Anschlussleitung verbunden ist, und eine zweite Anschlussfläche (914b), die sich auf der Leiterbahn (912) zwischen der ersten Anschlussfläche (914a) und dem Ausgang des elektronischen Schaltungsmoduls befindet und elektrisch mit der zweiten Anschlussleitung verbunden ist, aufweist, wobei die genannte elektronische Schaltungsvorrichtung so konfiguriert ist, dass das genannte auf dem Nacktchip untergebrachte passive Bauelement (922) mit der genannten ersten Anschlussleitung verbunden ist und das genannte Ausgangs- (920) -signal elektrisch mit der zweiten Anschlussleitung verbunden ist, wodurch der Strom von der ersten Anschlussfläche weg geleitet wird, wobei die elektronische Vorrichtung eine elektronische Hochfrequenz-Schaltungsvorrichtung ist, das Ausgangssignal ein Hochfrequenz-Ausgangssignal ist und der Strom ein Hochfrequenzstrom ist.

2. Elektronisches Schaltungsmodul nach Anspruch 1, wobei die erste und die zweite Anschlussfläche (914a, 914b) mit einem Nickel, Palladium und Gold enthaltenden Oberflächenplattierungsmaterial plattiert sind.

3. Elektronisches Schaltungsmodul nach Anspruch 1 oder Anspruch 2, wobei die erste Anschlussfläche (914a) und die zweite Anschlussfläche (914b) jeweils wenigstens einen Rand, wenigstens eine Seitenwand und eine Bondfläche haben, wobei der wenigstens eine Rand und die wenigstens eine Seitenwand von jeder von der ersten und der zweiten Anschlussfläche (914a, 914b) frei von Plattierungsmaterial ist.

4. Elektronisches Schaltungsmodul nach einem der Ansprüche 1 bis 3, wobei die erste Anschlussfläche (914a) und die zweite Anschlussfläche (914b) Drahtbond-Anschlussflächen sind.

5. Verfahren zur Herstellung eines elektronischen Schaltungsmoduls (900) zur Verringerung von Signalverlusten in dem elektronischen Schaltungsmodul, wobei das Verfahren Folgendes umfasst:
Herstellen einer elektronischen Schaltungsvorrichtung (918) mit: einem Nacktchip mit integrierter Schaltung, der ein auf dem Nacktchip untergebrachtes passives Bauelement (922) aufweist, und einem Ausgang (920), der zum Anlegen eines Ausgangssignals, das einen zugehörigen Strom aufweist, an das elektronische Schaltungsmodul (900) konfiguriert ist, wobei das elektronische Schaltungsmodul die elektronische Schaltungsvorrichtung umfasst;
Bilden einer ersten Anschlussleitung und einer zweiten Anschlussleitung an der elektronischen Schaltungsvorrichtung;
Bilden einer ersten Anschlussfläche (914a) und einer zweiten Anschlussfläche (914b) auf einem Substrat (910), wobei das elektronische Schaltungsmodul das Substrat (910) umfasst;
Bilden einer Leiterbahn (912) auf dem Substrat (10) zum Bereitstellen eines Leitwegs zum Leiten des Stroms zwischen der ersten und der zweiten Anschlussfläche (914a, 914b) und von dem genannten Ausgang (920) zu einem Ausgang des elektronischen Schaltungsmoduls;
elektrisches Verbinden der ersten Anschlussleitung mit der ersten Anschlussfläche (914a);
elektrisches Verbinden der zweiten Anschlussleitung mit der zweiten Anschlussfläche (914b), wobei sich die erste Anschlussfläche auf der Leiterbahn befindet, wobei sich die zweite Anschlussfläche auf der Leiterbahn (912) zwischen der ersten Anschlussfläche (914a) und dem Ausgang des elektronischen Schaltungsmoduls befindet; und
Konfigurieren der elektronischen Schaltungsvorrichtung, so dass das auf dem Nacktchip untergebrachte passive Bauelement (922) elektrisch mit der ersten Anschlussleitung verbunden wird und das Ausgangssignal elektrisch mit der zweiten Anschlussleitung verbunden wird, wodurch der Strom im Gebrauch von der ersten Anschlussfläche weg geleitet wird, wobei die elektronische Schaltungsvorrichtung eine elektronische Hochfrequenz-Schaltungsvorrichtung ist, das Ausgangssignal ein Hochfrequenz-Ausgangssignal ist und der Strom ein Hochfrequenzstrom ist.

## Revendications

1. Module de circuit électronique (900) configuré pour réduire les pertes de signal, ledit module comprenant :
un dispositif de circuit électronique (918) comportant : une puce de circuit intégré présentant un composant passif sur puce (922), une sortie (920) configurée pour fournir un signal de sortie ayant un courant associé au module de circuit électronique (900), une première broche de raccordement et une seconde broche de raccordement ;
un substrat (910) comprenant une piste (912) pour conduire le courant depuis ladite sortie (920) jusqu'à une sortie du module de circuit électronique, la piste comportant sur celle-ci un premier plot de connexion (914a) connecté électriquement à la première broche de raccordement et un second plot de connexion (914b) situé sur la piste (912) entre le premier plot de connexion (91 4a) et la sortie du module de circuit électronique et étant connecté électriquement à la seconde broche de raccordement, ledit dispositif de circuit électronique étant configuré de telle sorte que ledit composant passif sur puce (922) se connecte électriquement à ladite première broche de raccordement et que le signal de ladite sortie (920) se connecte électriquement à la seconde broche de raccordement, le courant étant ainsi dirigé loin du premier plot de connexion, le dispositif électronique étant un dispositif de circuit électronique radiofréquence, le signal de sortie étant un signal de sortie radiofréquence, et le courant étant un courant de radiofréquence.

2. Module de circuit électronique selon la revendication 1 dans lequel les premier et second plots de connexion (914a, 914b) sont plaqués avec un matériau de placage en surface comprenant du nickel, du palladium et de l'or.

3. Module de circuit électronique selon la revendication 1 ou la revendication 2 dans lequel le premier plot de connexion (914a) et le second plot de connexion (914b) comportent chacun au moins un bord, au moins un flanc et une zone de connexion, l'au moins un bord et l'au moins un flanc de chacun des premier et second plots de connexion (914a, 91 4b) étant dépourvus de matériau de placage.

4. Module de circuit électronique selon l'une quelconque des revendications 1 à 3 dans lequel le premier plot de connexion (914a) et le second plot de connexion (914b) sont des plots de connexion filaire.

5. Procédé de fabrication d'un module de circuit électronique (900) pour réduire les pertes de signal dans le module de circuit électronique, le procédé comprenant :
la fabrication d'un dispositif de circuit électronique (918) comprenant : une puce de circuit intégré présentant un composant passif sur puce (922) et une sortie (920) configurée pour fournir un signal de sortie ayant un courant associé au module de circuit électronique (900), le module de circuit électronique comprenant le dispositif de circuit électronique ;
la formation d'une première broche de raccordement et d'une seconde broche de raccordement sur le dispositif de circuit électronique ;
la formation d'un premier plot de connexion (914a) et d'un second plot de connexion (914b) sur un substrat (910), le module de circuit électronique comprenant le substrat (910) ;
la formation d'une piste (912) sur le substrat (910) pour fournir un chemin conducteur afin de conduire le courant entre les premier et second plots de connexion (914a, 914b) et depuis ladite sortie (920) jusqu'à une sortie du module de circuit électronique ;
la connexion électrique de la première broche de raccordement au premier plot de connexion (914a) ;
la connexion électrique de la seconde broche de raccordement au second plot de connexion (914b), le premier plot de connexion étant situé sur la piste, le second plot de connexion étant situé sur la piste (912) entre le premier plot de connexion (914a) et la sortie du module de circuit électronique ; et
la configuration du dispositif de circuit électronique de telle sorte que le composant passif sur puce (922) se connecte électriquement à la première broche de raccordement et que le signal de sortie se connecte électriquement à la seconde broche de raccordement, le courant étant ainsi dirigé loin du premier plot de connexion pendant l'utilisation, le dispositif de circuit électronique étant un dispositif de circuit électronique radiofréquence, le signal de sortie étant un signal de sortie radiofréquence, et le courant étant un courant de radiofréquence.
